# EUROPEAN PATENT SPECIFICATION

(11) **EP 0 502 368 B1**
(45) Date of publication and mention of the grant of the patent: **07.05.1997**
(21) Application number: 92102857.7
(22) Date of filing: 20.02.1992
(51) Int. Cl.: H03M 1/52

(54) **Integrating analog-to-digital converter**
Integrierender Analog-Digitalwandler
Convertisseur analogique-numérique à intégration

(30) Priority: 05.03.1991 JP 63954/91
(43) Date of publication of application: 09.09.1992
(73) Proprietor: YOKOGAWA INSTRUMENTS CORPORATION, Koushoku-shi, Nagano-ken 387 (JP)
(72) Inventor: Ishioka, Masakiyo, Nagano-shi, Nagano-ken 388 (JP)
(74) Representative: Henkel, Feiler, Hänzel & Partner

(56) References cited:
- US-A- 4 395 701

## Description

### BACKGROUND OF THE INVENTION

### Field of the Invention

The present invention relates to an analog-to-digital converter used for a digital voltmeter and a digital ohmmeter, etc. and more particularly to improvements of conversion accuracy and resolution of a double integral analog-to-digital converter.

### Description of the Related Art

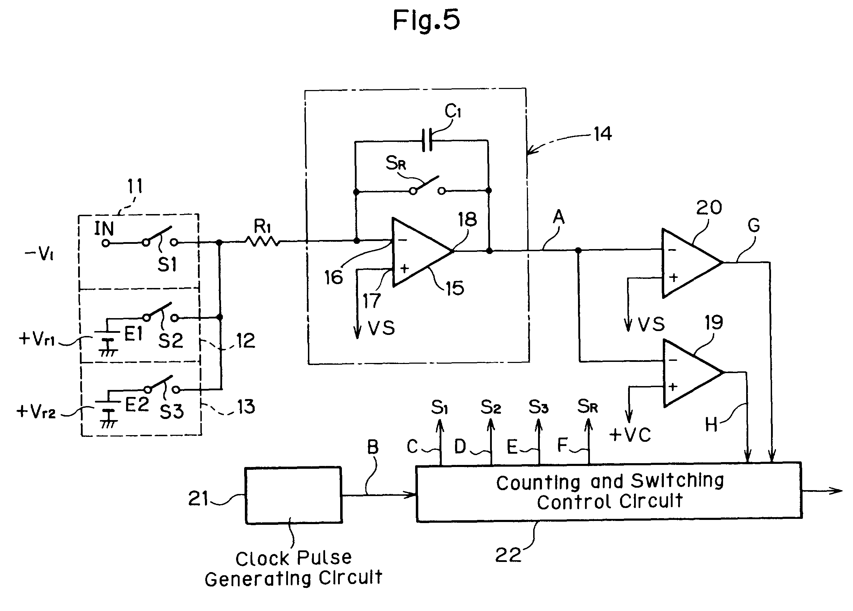

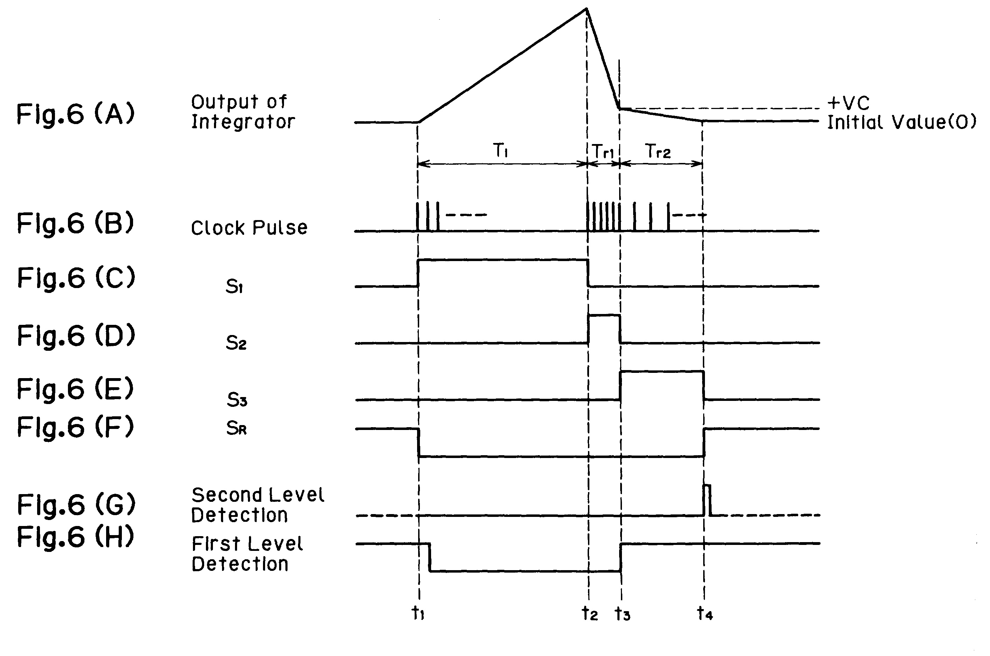

Among conventional analog-to-digital converters (referred to as an AD converter hereinafter) which are enhanced to be able to obtain high accuracy and high resolution, there is a triple integral AD converter. Fig. 5 shows one example of the triple integral AD converter and Fig. 6 is a time chart for explaining its operation. In the initial state (a state until time t1) in Fig. 6, switches S1, S2 and S3 are switched off, a reset switch SR is switched on and an integrator 14 is being reset. Then the switch S1 is switched on for a predetermined period of time (Ti) from time t1 to time t2 to integrate a voltage to be measured -Vi. An output of the integrator 14 increases in the positive direction as shown by A in Fig. 6. This period of time Ti is controlled by counting clock pulses by a counting and switching control circuit 22. Upon reaching to time t2, the switch S1 is switched off and the switch S2 is switched on to integrate a first reference voltage +Vr1 having a reversed polarity to the voltage -Vi to be measured. During this period, the time is measured utilizing high speed clock pulses. When the output of the integrator 14 reaches to a first detection level +VC, it is detected by a first level detector 19 as shown by H in Fig. 6 and the switch S2 is switched off and the switch S3 is switched on synchronizing with the clock pulses. Thereby a second reference voltage +Vr2 which is lower than the first reference voltage +Vr1 is supplied to the integrator 14 to be integrated. The output of the integrator 14 decreases toward the initial value 0 V with a gentle slope. During this Tr2 period (t3 to t4), the time is measured by low speed clock pulses. When the output of the integrator 14 reaches to 0 V, it is detected by a second level detector 20 and the switch S3 is switched off and the reset switch SR is switched on to end the AD conversion.

Since an amount of charge accumulated during t1 to t2 period and an amount of charge released during t2 to t4 period (Tr1 + Tr2) are equal in this case, a digital value of the voltage to be measured can be found by weighted sum of the number of pulses in the period Tr1 and that in the period Tr2.

In short, this triple integral AD converter is a system which divides integrating periods by the reference voltages into integration of the first reference voltage and that of the second reference voltage and to integrate roughly in the first half and finely in the second half by making the slope gentle.

However, this system has disadvantages that it requires two types of clock pulses, two different types of reference voltages having different voltages and another comparator and comparison level for changing a slope of the integration besides a comparator for detecting a crossing with a reference level.

Accordingly, it is an object of the present invention to eliminate the aforementioned disadvantages by providing an integral AD converter which allows to increase a number of digits of AD conversion and to realize high conversion accuracy and high resolution by enlarging a time from a crossing point with the reference level to a clock pulse immediately after the crossing in the reference voltage integrating period without changing frequency of the clock pulses and by counting this interval by clock pulses having the same frequency.

### SUMMARY OF THE INVENTION

In order to attain the aforementioned goal, the present invention comprises:
an integrator for integrating by a voltage to be measured connected to an input terminal and by a reference voltage having a reversed polarity to the voltage to be measured;
a memory capacitor which is connected to an output of the integrator and which is disconnected when the integrated output is synchronized with a clock pulse after passing through a reference level to memorize a potential of the integrated output at the time when it is synchronized with the clock pulse;
potential dividing resistors which are connected to the output of the integrator and divide the integrated output by a predetermined ratio;
a comparator for detecting that the integrated output has passed through the reference level, for comparing successively the potential memorized in the memory capacitor and a potential of the integrated output divided by the potential dividing resistor and for outputting a signal for terminating the integration when those potentials coincide;
a clock pulse generating circuit for generating clock pulses;
a counter for counting a period until the integrated output when the reference voltage is connected passes through the reference level, by using the clock pulses;
a reversible counter for counting a period from when the integrated output passes through the reference level to when the integration is finished, by the clock pulses and for adding its value to a counted value of the counter as low order digits; and
a control circuit for controlling supply of the voltage to be measured or of the reference voltage to the integrator, supply of the output of the integrator to the memory capacitor, supply of a predetermined input voltage to the comparator and supply of the clock pulses to the counter and the reversible counter.

In a system as described above, integration by the voltage to be measured is carried out in the first integrating period and after that, integration by the reference voltage is carried out until the integrated voltage reaches to the reference level. The integrating period by the reference voltage is counted by the reference clock pulses, and there is an error in the value counted at this time. That is, a time from time when the integrated voltage actually crosses the reference level to time of the final clock pulse counted becomes the error. In the present invention, the time which corresponds to the error is enlarged and is counted using the clock pulses to enhance the conversion accuracy and resolution.

### BRIEF DESCRIPTION OF THE DRAWINGS

Fig. 1 is a diagram illustrating a construction of a main part of one embodiment of an AD converter according to the present invention;
Fig. 2 is a time chart for explaining operation of the system in Fig. 1;
Fig. 3 is a partially enlarged diagram of the time chart in Fig. 2;
Fig. 4 is a partially enlarged diagram of the time chart in Fig. 2;
Fig. 5 is a diagram illustrating a construction of one example of a prior art triple integral AD converter; and
Fig. 6 is a time chart for explaining operation of the system in Fig. 6.

### DETAILED DESCRIPTION OF PREFERRED EMBODIMENT

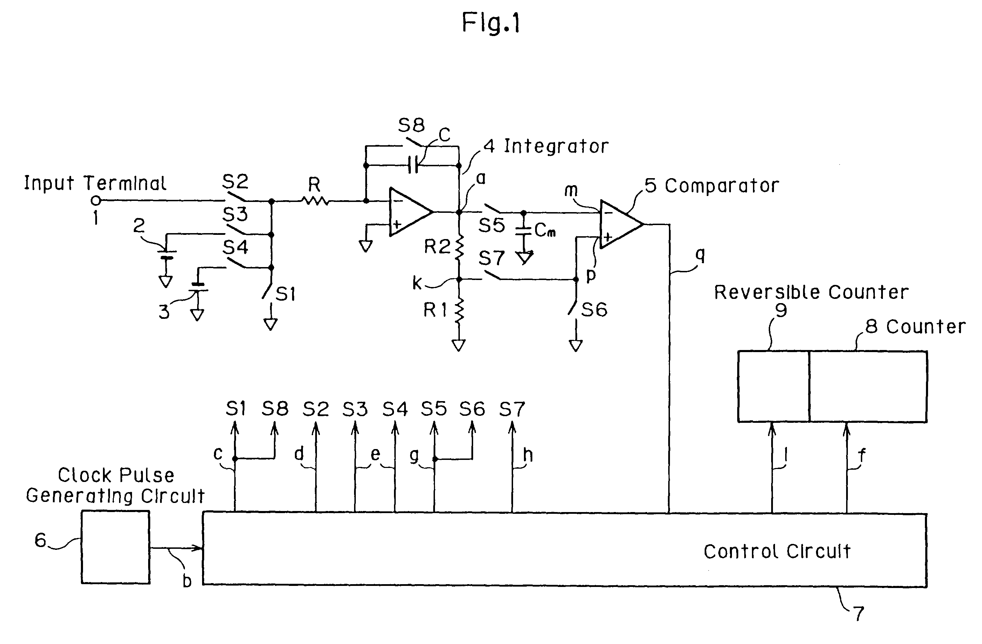

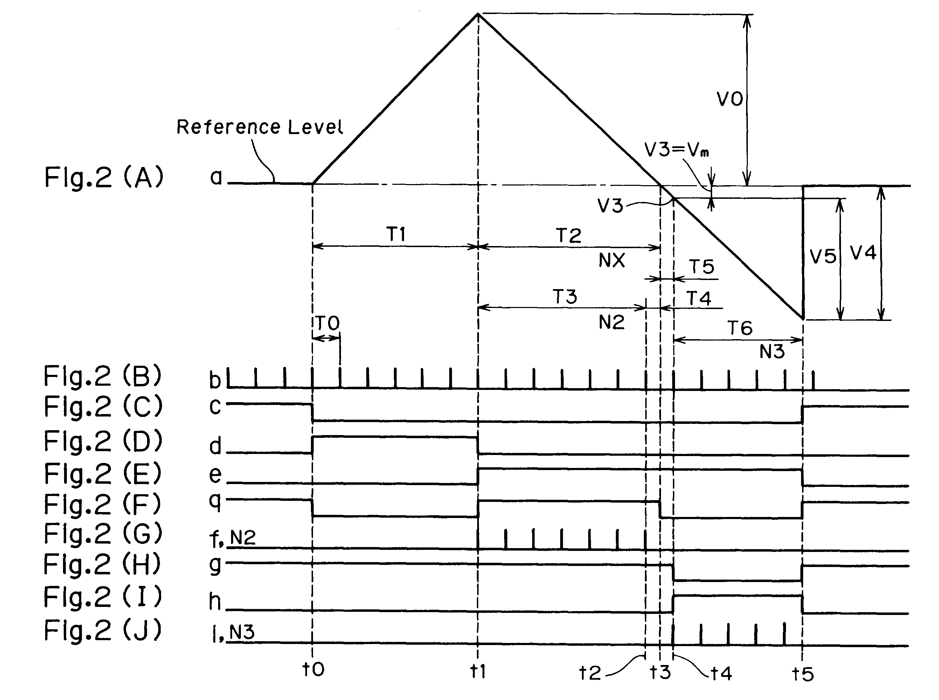

Referring now to the drawings, the present invention will be explained in detail. Fig. 1 is a diagram illustrating a construction of a main part of one embodiment of an AD converter according to the present invention and Fig. 2 is a time chart for explaining its operation. In Fig. 1, the reference numeral and character (1) denotes an input terminal through which a voltage to be measured Vx is applied, (2) and (3) reference voltages whose voltage is equal but only their polarity differ each other, (4) an integrator, (5) a comparator, (6) a clock pulse generating circuit, (7) a control circuit, (8) a counter, (9) a reversible counter, (R1) and (R2) potential dividing resistors and (Cm) a memory capacitor.

The integrator 4 is provided with an integrating resistor R at the input end and comprises an amplifier A provided with a parallel connection circuit of an integrating capacitor and a reset switch S8 at its feedback path. At the input side of the integrating resistor R, a common line, the voltage to be measured, the reference voltages 2 and 3 are connected respectively through switches S1, S2, S3 and S4. On and off of each switch S1, S2, S3 and S4 are controlled by the controller 7.

The potential dividing resistors R1 and R2 are connected in series and the other end of R2 is connected to an output end of the integrator 4 and the other end of R1 is connected to the common line. The memory capacitor Cm is connected to the output end of the integrator 4 through an intermediary of a switch S5.

One input end of the comparator 5 is connected to the memory capacitor Cm and the other input end is connected to a common connecting point K of the potential dividing resistors R1 and R2 through an intermediary of a switch S7 and to the common line through an intermediary of a switch S6. The comparator 5 outputs a binary signal corresponding to a relationship of magnitude between the two inputs.

The control circuit 7 receives clock pulses b (see Fig. 2B) supplied from the clock pulse generating circuit 6 and controls each switch and outputs clock pulses to be counted in the counter 8 and reversible counter 9.

Referring next to the time chart in Fig. 2, operation of the system structured as described above will be explained. In the initial state before starting conversion, the voltage to be measured Vx is applied to the input terminal1, the switches S1, S8, S5 and S6 are switched on and all other switches are being switched off. These switches are controlled by the control circuit 7.

The switches S1 and S8 are switched off and the switch S2 is switched on at the starting time of the conversion t0. Then the voltage to be measured Vx is added to the integrator 4 through the intermediary of the integrating resistor R and integration is carried out for a predetermined period of time (during T1). This period shall be called a first integrating period.

At the end of the integrating period, an integrated output V0 is calculated by the following expression (1):$\text{V0 = -Vx ∗ T1/(R ∗ C)}$

The predetermined time T1 is determined by counting the clock pulses b given from the clock pulse generating circuit 6 by the controller 7. When the number of clock pulses is N1 and the period of the clock pulse b is T0, T1 is calculated as follows:$\text{T1 = N1 x T0}$ If expression (2) is substituted for expression (1), it becomes as follows:$\text{V0 = -Vx (N1 ∗ T0)/(R ∗ C)}$

Upon ending the integration of the predetermined period of time T1, the switch S2 is switched off and the switch S3 (or switch S4) is switched on and either one reference voltage 2 or 3 having a reverse polarity to the voltage to be measured Vx connected to the input terminal 1 is selected. The control circuit 7 judges which one among the switches S3 and S4 should be switched on in accordance to an output from the comparator 5.

The reference voltage is connected to the integrator 4 through the integrating resistor R and is integrated. At this time, a slope of the integration is reversed from that in the first integrating period. The comparator 5 detects when the integrated output passes through the reference level. This period of time from starting of the integration of the reference voltage 2 or 3 to the passing thereof of the reference level shall be called as a second integrating period.

Where the reference voltage is Vr, the reference level is 0, and a time width of the second integrating period is T2, the reference level 0 is calculated as follows:$\text{0 = V0 - (-Vr) ∗ T2/(R ∗ C)}$ Therefore, T2 is;$\text{T2 = -(R ∗ C) ∗ V0/Vr}$ When expression (3) is substituted for the above expression, it becomes as follows:$\text{T2 = -Vx (N1 ∗ T0)/Vr}$ This second integrating period is counted by the counter 8 using the clock pulses b sent out from the clock pulse generating circuit 6. When the number of clock pulses sent out to the counter 8 is Nx, it becomes as follows:$\text{Nx = T2/T0}$ When expressions (6) and (7) are adjusted, it becomes as follows:$\text{Nx = Vx ∗ N1/Vr}$ Up to now, the operations are the same with those of the prior art double integral AD converter and expression (8) is its typical conversion formula.$\text{Here, T2 is;}$$\text{T2 = T3 + T4}$ and if it is substituted for expression (7), it becomes as follows:$\text{Nx = T3/T0 + T4/T0}$ T3/T0 is an amount of the clock pulses b having a period T0 is sent out to the counter 8. If this is N2 (see Fig. 2G), the number of clock pulses Nx sent out to the counter 8 is;$\text{Nx = N2 + T4/T0}$

In the prior art double integral AD converter, the total number of the clock pulses N2 during this second integrating period is dealt as AD conversion amount and T4/T0 is cut off as an error since T4 < T0. However, if this time width of T4 can be counted using the clock pulses b, it follows that the accuracy is increased and the resolution is enhanced without increasing speed of the clock pulses.

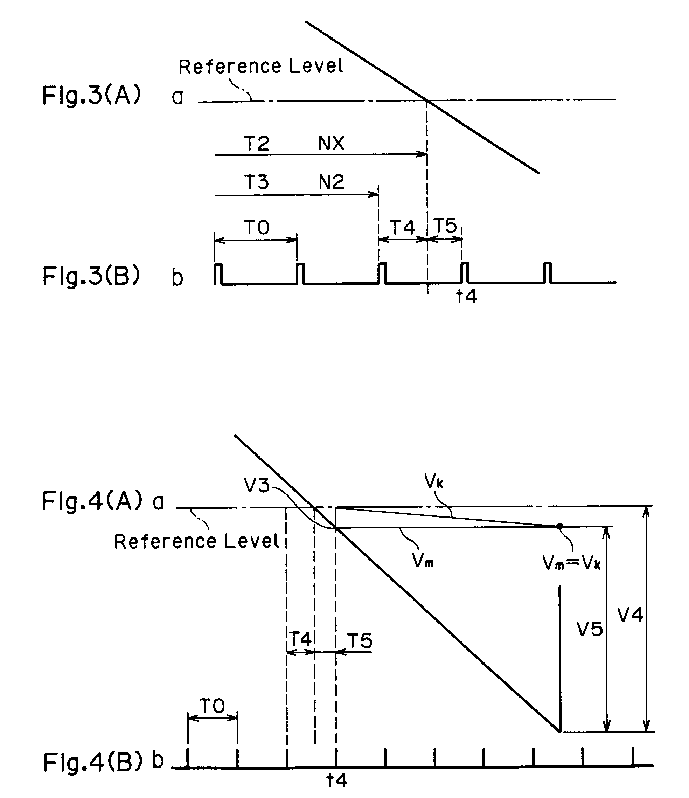

In the present invention, a time width T5 from the reference level passing point to the next clock pulse t4 is found as shown in Fig. 3. To this end, the time width T5 is enlarged to count using the clock pulses b and to find T4 equivalent by operation to increase the accuracy and to enhance the resolution.

A relationship of T4 and T5 is;$\text{T4 = T0 - T5}$ Therefore, it becomes as follows:$\text{T5 = T0 - T4}$

Now, operations how to count enlarging T5 and using the clock pulses b will be explained. Following to the second integrating period, the integration by the reference voltage 2 (or 3) is continued (this period shall be called a third integrating period). At a point when it is synchronized with the clock pulse b after passing through the reference level, the switch S5 is switched off and its potential is memorized in the memory capacitor Cm.

If the output of the integrator 4 at this time is V3 and the potential memorized in the memory capacitor Cm is Vm, it becomes as follows:$\text{Vm = V3}$

Since V3 is the integrated output by the reference voltage 2 (or 3) from the reference level passing point, it is expressed by the following expression:$\text{V3 = -Vr ∗ T5/(R ∗ C)}$

Then at this time, the switch S6 is switched off and the switch S7 is switched on and the potential dividing point k of the potential dividing resistors R1 and R2 having a potential dividing ratio n is connected to the input p of the comparator 5. The potential dividing ratio n and a ratio of potential dividing resistances R1 and R2 are predetermined as follows:$\text{n : 1 = R2 : R1}$

Therefore, it becomes as follows:$\text{n = R2/R1}$

The output of the integrator 4 is divided in the above potential dividing ratio at time t4 and is connected to the input p of the comparator 5. The integrator 4 continuously integrates by the reference voltage 2 (or 3) even after the third integrating period. The comparator 5 compares the potential at the potential dividing point k and the potential Vm memorized in the memory capacitor Cm and if the potential Vk at the dividing point k exceeds that of Vm as shown in Fig. 4, the output q of the comparator 5 is reversed. The period up to now shall be called a fourth integrating period.

The output V4 of the comparator 5 when Vk = Vm is expressed as follows:$\text{V4 ∗ R1/(R1 + R2) = Vm}$ When expressions (14), (17) and (18) are adjusted about V4, it becomes as follows:$\text{V4 = V3 + nV3}$ An amplitude of the integrator 4 at time t5 at the end of the fourth integrating period is;$\text{V5 = V4 - V3}$ When expression (19) is substituted for expression (20), it becomes as follows:$\text{V5 = nV3}$ That is, the output V3 of the integrator 4 when it was synchronized with the clock pulse b after passing through the reference level is enlarged by n times at the end of the fourth integrating period.

On the other hand, since the outputs of the integrator 4 during this period and in the third integrating period are what are integration by the reference voltage 2 (or 3), it becomes as follows:$\text{V4 = -Vr (T5 + T6)/(R ∗ C)}$ The amplitude V5 of the integrator 4 in a T6 period is calculated from expressions (15), (20) and (22) as follows:$\text{V5 = -Vr ∗ T6/(R ∗ C)}$ Therefore, when expressions (21) and (23) are adjusted, it becomes as follows:$\text{n ∗ V3 = -Vr ∗ T6/(R ∗ C)}$ When expression (24) is substituted for expression (15), the following expression can be obtained:$\text{n ∗ T5 = T6}$

This means that T5 could be enlarged by the potential dividing ratio n of the potential dividing resistances. An accuracy when T5 is enlarged depends on the dividing ratio n of the potential dividing resistances. The total number N3 of the clock pulses with T0 of period and gate passing clock pulses i (see Fig. 2J) due to this enlarged T6 is;$\text{N3 = T6/T0}$ Then from expressions (12), (25) and (26), it becomes as follows:$\text{T4 = T0 (n - N3)/n}$ This means that T4 could be counted by the clock pulses b with T0 of period and T0/n corresponds to that the speed of the clock pulses b is increased by n times. This total number of clock pulses N3 is also sent out to the reversible counter 9 to count and operate = (n - N3) here and to add up by weighting N2 calculated in the previous second integrating period. The total sum Nx of digital conversion amount at this time is calculated as follows. When expression (27) is substituted for expression (11), it becomes as follows:$\text{Nx = N2 + (n - N3)/n}$ When the both sides are multiplied by n, it will be:$\text{n ∗ Nx = n ∗ N2 + (n - N3)}$ When the above expression is adjusted, it becomes as follows:$\text{n ∗ Nx = n (N2 + 1) - N3}$

Thus Nx is weighted by n times, allowing to obtain a resolution in which the lower order digit is increased by n times. That is, if n is 10 or 100, it follows that the accuracy and resolution of the AD conversion are enhanced by 10 times or 100 times.

At the end of the fourth integrating period, the switch S3 or S4 which is switched on by the reverse signal of the comparator 5 is switched off and the switches S1, S8, S5 and S6 are switched on to return to the initial state and to end the conversion.

As described above in detail, the present invention allows to readily enhance the conversion accuracy and the resolution and provides the following effects:
1) The period of the clock pulses needs not be changed. Therefore, the circuit structure can be simplified as compare to the prior art example.
2) Only one comparator will do. Since the present invention does not require two comparators as in the prior art example, it also allows the circuit structure to be simplified.
3) The resolution can be enhanced without prolonging the conversion time. That is, the resolution can be enhanced by n times by the potential dividing resistance ratio n regardless of the size of a number of conversion digits. A time necessary for enhancing the resolution by n time is a time of just n clock pulses which is relatively small.
4) A plurality of reference voltages having different voltages is not necessary as in the prior art example. Therefore, it also allows the circuit structure to be simplified.

## Claims

1. An integral analog-to-digital converter, comprising: an integrator (4) for integrating by a voltage to be measured connected to an input terminal (1) and by a reference voltage having a reversed polarity to said voltage to be measured;
a memory capacitor (Cm) which is connected to an output (a) of said integrator (4) and which is disconnected when an integrated output is synchronized with a clock pulse after passing through a reference level to memorize a potential of said integrated output at said time when it is synchronized with said clock pulse;
potential dividing resistors (R1, R2) which are connected to said output (a) of said integrator (4) and divide said integrated output by a predetermined ratio;
a comparator (5) for detecting that said integrated output has passed through said reference level, for comparing successively said potential memorized in said memory capacitor (Cm) and a potential of said integrated output divided by said potential dividing resistors (R1, R2) and for outputting a signal (q) for terminating said integration at a point when those potentials coincide;
a clock pulse generating circuit (6) for generating said clock pulses;
a counter (8) for counting a period till said integrated output when said reference voltage is connected passes through said reference level, by using said clock pulses;
a reversible counter (9) for counting a period from when said integrated output passes through said reference level to when said integration is finished, by said clock pulses and for adding its value to a counted value of said counter as low order digits; and
a control circuit (7) for controlling supply of said voltage to be measured or of said reference voltage to said integrator (4), supply of said output of said integrator (4) to said memory capacitor (Cm), supply of a predetermined input voltage to said comparator (5) and supply of said clock pulses to said counter (8) and said reversible counter (9) : and
said converter being characterized in that said counted value in said period from said reference level passing point to said end of integration is added up as said lower order digits to said counted value in said period before said reference level passing point to enhance a resolution of the conversion.

## Patentansprüche

1. Integrierender Analog-Digitalwandler, umfassend:
einen Integrator (4) zur Integrierung über die zu messende Spannung, der mit einem Eingangsanschluß (1) verbunden ist, und über eine Referenzspannung mit einer zur zu messenden Spannung umgekehrten Polarität;
einen an einem Ausgang (a) des Integrators angeschlossenen Speicherkondensator (Cm), der getrennt wird, wenn ein integrierter Ausgang mit einem Taktimpuls synchronisiert wird, nachdem er einen Referenzpegel zur Speicherung eines Potentials des integrierten Ausgangs zum Zeitpunkt der Synchronisierung mit dem Taktimpuls durchlaufen hat;
Potentialteilungswiderstände (R1, R2), die an den Ausgang (a) des Integrators (4) angeschlossen sind und den integrierten Ausgang in einem vorgegebenen Verhältnis teilen;
einen Komparator (5) zur Erkennung, ob der integrierte Ausgang den Referenzpegel durchlaufen hat, zum fortlaufenden Vergleich des im Speicherkondensator (Cm) gespeicherten Potentials mit einem durch die Potentialteilungswiderstände (R1, R2) geteilten Potential des integrierten Ausgangs und zur Ausgabe eines Signals (9) zur Beendigung der Integrierung an einem Punkt, an dem diese Potentiale übereinstimmen;
eine Taktimpulsgeneratorschaltung (6) zur Erzeugung der Taktimpulse;
einen Zähler (7) zur Zählung einer Periode,bis der integrierte Ausgang bei angeschlossener Referenzspannung den Referenzpegel durchläuft,mittels der Taktimpulse;
einen Zweirichtungszähler (9) zur Zählung einer Periode, ab der der integrierte Ausgang den Referenzpegel durchläuft, bis zum Abschluß der Integrierung auf Basis der Taktimpulse und zur Addition dieses Werts zu einem Zählwert des Zählers als niederwertige Bits;
und
eine Steuerschaltung (7) zur Steuerung der Zufuhr der zu messenden Spannung oder der Referenzspannung zum Integrator (4), zur Übergabe des Ausgangs des Integrators (4) an den Speicherkondensator (Cm), zur Bereitstellung einer vorgegebenen Eingangsspannung für den Komparator (5) und zur Übergabe der Taktimpulse an den Zähler (7) und den Zweirichtungszähler (9);
wobei der Wandler dadurch gekennzeichnet ist, daß der die Periode vom Durchgangspunkt durch den Referenzpegel zum Abschluß der Integrierung erfassende Zählwert als niederwertige Bits zu dem Zählwert addiert wird, der die Periode vor dem Durchgangspunkt durch den Referenzpegel erfaßt, um eine Auflösung der Umwandlung zu verbessern.

## Revendications

1. Un convertisseur analogique-numérique à intégration comportant :
un intégrateur (4) pour intégrer une tension à mesurer reliée à une borne d'entrée (1) et une tension de référence présentant une polarité inverse de la tension à mesurer ;
un condensateur de mémoire (Cm) qui est relié à une sortie (a) dudit intégrateur (4) et qui est déconnecté lorsqu'une sortie intégrée est synchronisée avec une impulsion d'horloge après le passage par un niveau de référence pour mémoriser un potentiel de ladite sortie intégrée audit instant où elle est synchronisée avec ladite impulsion d'horloge ;
des résistances (R1, R2) de division de potentiel qui sont reliées à ladite sortie (a) dudit intégrateur (4) et divisent ladite sortie intégrée dans un rapport prédéterminé ;
un comparateur (5) pour détecter que ladite sortie intégrée est passée par ledit niveau de référence, pour comparer successivement ledit potentiel mémorisé dans ledit condensateur de mémoire (Cm) et un potentiel de ladite tension intégrée divisée par lesdites résistances (R1, R2) de division de potentiel et pour donner en sortie un signai (q) pour arrêter ladite intégration à un point où ces potentiels coïncident ;
un circuit (6) de création d'impulsions d'horloge pour engendrer lesdites impulsions d'horloge ;
un compteur (8) pour compter une période jusqu'à ce que ladite sortie intégrée, lorsque ladite tension de référence est connectée, passe par ledit niveau de référence, en utilisant lesdites impulsions d'horloge ;
un compteur réversible (9) pour compter une période depuis l'instant où ladite tension intégrée passe par ledit niveau de référence jusqu'à l'instant où ladite intégration est terminée, par lesdites impulsions d'horloge, et pour ajouter sa valeur à une valeur comptée dudit compteur en tant que digits d'ordre bas ; et
un circuit de commande (7) pour commander l'application de ladite tension à mesurer ou de ladite tension de référence audit intégrateur (4), l'application de ladite sortie dudit intégrateur (4) audit condensateur de mémoire (Cm), l'application d'une tension d'entrée prédéterminée audit comparateur (5), et l'application desdites impulsions d'horloge audit compteur (8) et audit compteur réversible (9) ; et
ledit convertisseur étant caractérisé en ce que ladite valeur comptée dans ladite période depuis ledit point de passage par le niveau de référence jusqu'à ladite fin d'intégration est ajoutée, en tant que digits d'ordre inférieur, à ladite valeur comptée dans ladite période avant ledit point de passage par le niveau de référence pour augmenter la résolution de la conversion.
